# EUROPÄISCHE PATENTSCHRIFT

(11) **EP 2 348 799 B1**
(45) Veröffentlichungstag und Bekanntmachung des Hinweises auf die Patenterteilung: **06.08.2014**
(21) Anmeldenummer: 10014966.5
(22) Anmeldetag: 25.11.2010
(51) Int. Cl.: H05K 1/18

(54) **Elektronisches Steuergerät und Gasentladungslampe für eine Beleuchtungseinrichtung eines Kraftfahrzeugs mit einem solchen Steuergerät**
Electronic control device and gas discharge lamp for a lighting device of a motor vehicle with such a control device
Appareil de commande électronique et lampe à décharge pour un dispositif d'éclairage d'un véhicule automobile doté d'un tel appareil de commande

(30) Priorität: 22.12.2009 DE 102009060780
(43) Veröffentlichungstag der Anmeldung: 27.07.2011
(73) Patentinhaber: Automotive Lighting Reutlingen GmbH, 72762 Reutlingen (DE)
(72) Erfinder: Brendle, Matthias, 72074 Tübingen (DE)
(74) Vertreter: DREISS Patentanwälte PartG mbB

(56) Entgegenhaltungen:
- EP-A2- 0 827 372
- WO-A1-93/11654
- DE-A1- 3 936 906
- US-A- 5 434 362
- US-A1- 2005 041 399
- US-A1- 2005 190 531
- US-A1- 2007 212 902

## Beschreibung

Die vorliegende Erfindung ist in den beigefügten Ansprüchen definiert. Sie betrifft ein elektronisches Steuergerät, insbesondere ein Steuergerät für eine Beleuchtungseinrichtung eines Kraftfahrzeugs. Das Steuergerät umfasst eine mit elektrischen Leiterbahnen versehene und mit elektronischen Bauteilen bestückte Leiterplatte sowie einen mit der Leiterplatte in thermischem Kontakt stehenden Grundkörper aus einem Material mit hoher Wärmeleitfähigkeit. Die Erfindung betrifft außerdem eine Gasentladungslampe für eine Beleuchtungseinrichtung eines Kraftfahrzeugs. Die Lampe umfasst einen Brenner, ein Zündgerät und ein Steuergerät.

Elektronische Steuergeräte, insbesondere im Kraftfahrzeugbereich, sind zum Schutz vor Verschmutzung, Feuchtigkeit und mechanischen Einwirkungen von außen in einem Steuergerätegehäuse angeordnet. Zur Verbesserung der EMV-Verträglichkeit bestehen diese Gehäuse zumindest teilweise aus Metall. Dabei gibt es häufig einen Zielkonflikt zwischen einer möglichst kleinen Geometrie des Steuergeräts einerseits und der Vermeidung eines Wärmestaus im Inneren des Steuergerätegehäuses andererseits. Insbesondere führen wachsende Anforderungen an die Funktionalität, Sicherheit und Leistung von Kraftfahrzeugen sowie die damit einhergehende Vielzahl an Hilfsaggregaten, zu einer starken Überfrachtung des Fahrzeugbauraums sowie der einzelnen Fahrzeugkomponenten. Dieser Zwang zu kleinbauenden Modulen erstreckt sich mittlerweile auch auf Elektronikbaugruppen und Steuergeräte, die zunehmend mit wachsender Funktionalität im Scheinwerfer zum Einsatz kommen. Insbesondere neuere Bestrebungen, Zünder und Steuergerät in eine Gasentladungs-Lichtquelle zu integrieren, stellen hohe Anforderungen an eine kompakte Bauweise der integrierten Elektronik, da eine Vergrößerung des Bauvolumens dem universellen Ansatz und damit der Standardisierung einer solchen Lichtquelle entgegenstehen würde.

Heutige Steuergeräte für Beleuchtungseinrichtungen bauen relativ groß: So enthalten die meisten Steuergeräte lediglich eine starre, ebene Leiterplatte, deren Grundfläche im Wesentlichen auch die Größe der Steuergerätebaugruppe bestimmt. Dabei wird die Leiterplatte meist thermisch an eine Seite des Steuergerätegehäuses angebunden, über die dann die Verlustleistung der Elektronik (Wärme) abgeführt wird.

Alternativ zu starren Leiterplatten finden in zunehmendem Maße auch dünne flexible Leiterplatten, z.B. auf Basis von Polyimid-Folien, Verwendung. Die damit aufgebauten sog. Flexschaltungen können durch Umformung, bspw. Falten, Biegen oder Rollen, platzsparend in engsten Strukturen z.B. in Fotoapparaten und Videokameras, eingesetzt werden.

Nachteilig bei diesen flexiblen Leiterplatten sind jedoch die relativ hohen Kosten, die schlechte Wärmeabfuhr der von den elektrischen Bauteilen während des Betriebs erzeugten Abwärme sowie die fehlende mechanische Formstabilität der Leiterplatte. Dadurch wird die Bestückung der Leiterfolie mit herkömmlichen Bestückungsautomaten erschwert, und die mechanische Stabilisierung der bestückten Leiterplatte, bspw. im Steuergerätegehäuse, erweist sich als sehr aufwendig.

Falls nur ein nicht dauerhaft flexibler Bereich in der Leiterplatte benötigt wird, z.B. um die Montage bei engen Bauraumverhältnissen zu ermöglichen, ist es ferner bekannt, die Materialstärke einer bestückten starren Leiterplatte z.B. durch Fräsen zu verringern. Der verjüngte Bereich kann dann wenige Male gebogen werden. Diese Technik führt zu sog. Starrflex-Leiterplatten. Nachteilig bei dieser Technologie ist allerdings, dass je Biegekante nur eine eindimensionale Verformung möglich ist. Besonders nachteilig bei beengten Platzverhältnissen ist zudem der notwendige relativ große Biegeradius und die damit entfallende Bestückungsfläche in der Biegezone, da eine Bestückung der Leiterplatte nur außerhalb der Biegezone möglich ist.

Schließlich ist zur Vermeidung der Nachteile beim Einsatz von Flexleiterplatten aus dem Stand der Technik ein Aufbau bekannt, bei dem die bestückte flexible Leiterfolie auf einen starren Grundkörper als Träger aufgebracht und z.B. durch Kleben mit diesem verbunden wird. Nachteilig ist hierbei jedoch, dass zur Vermeidung unzulässiger Materialbeanspruchung aufgrund unterschiedlicher Biegeradien das starre Trägermaterial im Knickbereich unterbrochen werden muss. Zur mechanischen Stabilisierung muss dieser Aufbau also mit einem zusätzlichen Konstruktionselement verbunden werden. Außerdem erweist sich auch bei dieser Technologie die Bestückung der flexiblen Leiterplatte aufgrund der fehlenden Formstabilität als aufwendig. Schließlich ist das Aufbringen und Befestigen der bestückten Leiterplatte auf dem Grundkörper aufwendig und kompliziert. Es besteht die Gefahr einer Zerstörung der elektrischen Bauteile oder eines Lösens der Bauteile von der Leiterplatte während des Befestigungsvorgangs.

Bei elektronischen Steuergeräten ist es auf Grund thermischer Anforderungen und Gegebenheiten meist erforderlich, die elektrischen Komponenten (Bauteile) in geeigneter Weise zu kühlen. Dies kann bspw. durch mechanische Anbindung an einen Kühlkörper erfolgen, über den die Wärme abtransportiert und an die Umgebung abgegeben werden kann.

US 2005/01900531 beschreibt ein Steuergerät, welches eine bestückte Leiterplatte sowie einen mit der Leiterplatte in thermischem Kontakt stehenden Grundkörper aus einem Material mit hoher Wärmeleitfähigkeit umfasst, wobei der Grundkörper im Bereich von Biegezonen geschlitzt ist.

EP 0 827 372, das als nächster Stand der Technik angesehen wird, beschreibt ein Steuergerät, welches eine bestückte Leiterplatte sowie einen mit der Leiterplatte in thermischem Kontakt stehenden Grundkörper aus einem Material mit hoher Wärmeleitfähigkeit umfasst, wobei der Grundkörper im Bereich von Biegezonen Nuten aufweist. Die gefaltete Einheit ist in einen Gehäuserahmen eingesetzt.

Ausgehend von dem beschriebenen Stand der Technik liegt der vorliegenden Erfindung die Aufgabe zugrunde, eine Verbesserung der Herstellung einer Einheit aus Leiterplatte und Grundkörper für ein Steuergerät vorzuschlagen, durch welche die Nachteile des Standes der Technik vermieden werden. Insbesondere soll die vorliegende Erfindung eine optimale Anbindung wärmeabgebender Bauteile an einen Kühlkörper bei Verwendung von flexiblen Leiterplatten ermöglichen. Ein weiteres Ziel ist eine optimale Ausnutzung des zur Verfügung stehenden Volumens und der Leiterplattenoberfläche für die Platzierung von elektrischen und elektronischen Komponenten im Steuergerät bei gleichzeitiger Verbesserung der Wärmeabfuhr von Aufbauten und dreidimensional geformten flexiblen Leiterplatten. Schließlich soll die für die elektronischen Komponenten zur Verfügung stehende Fläche möglichst groß sein und während der Bestückung sowie während der Verwendung des Steuergeräts eine hinreichende Festigkeit für oberflächenmontierte Bauelemente bestehen.

Zur Lösung dieser Aufgabe wird ausgehend von dem Steuergerät der eingangs genannten Art vorgeschlagen, dass die Leiterplatte bzw. die Leiterbahnen vor der Bestückung mit den elektrischen Bauteilen auf eine Abwicklung des Grundkörpers aufgebracht und zumindest bereichsweise darauf befestigt sind, und dass eine Umformung der bestückten Grundkörper-Leiterplatten-Einheit bzw. Grundkörper-Leiterbahnen-Einheit in eine gewünschte Geometrie nach der Bestückung mit den elektronischen Bauteilen erfolgt, wobei der Grundkörper zumindest einen Teil des Steuergerätegehäuses bildet.

Mit der vorliegenden Erfindung sind komplexe dreidimensionale Leiterplattenformen in elektronischen Steuergeräten realisierbar. Dabei werden die Nachteile des Standes der Technik von mit flexiblen Leiterplatten realisierten Aufbauten wie schlechte Wärmeabfuhr, geringe Formstabilität und schwierige Bestückung mit herkömmlichen Bestückungsautomaten vermieden. Gleichzeitig werden jedoch die Vorteile flexibler Leiterplatten wie hohe Zuverlässigkeit bei hohen Temperaturen und dreidimensionale Formbarkeit beibehalten. Der Grundkörper besteht aus einem Material mit hoher Wärmeleitfähigkeit, wie bspw. Metall, und bildet gleichzeitig einen Kühlkörper, über den die Abwärme abgeführt werden kann.

Durch das Aufbringen und zumindest partielle Befestigen des Substrats auf der Abwicklung des Grundkörpers sind verschiedene Vorteile verbunden. Zunächst kann eine optimale thermische Anbindung des Substrats an den Grundkörper sichergestellt werden. Das Aufbringen des Substrats auf den Grundkörper erfolgt bspw. mittels einer Klebeverbindung oder durch Auflaminieren. Selbstverständlich kann das Aufbringen auch auf beliebig andere geeignete Weise erfolgen. Wichtig bei der Wahl eines geeigneten Verfahrens zum Aufbringen des Substrats auf den Grundkörper ist dabei insbesondere, dass eine gute thermische Anbindung des Substrats bzw. der elektrischen und elektronischen Komponenten (Bauteile) des Steuergeräts an den Grundkörper gewährleistet wird. Bei der Befestigung des Substrats auf dem Grundkörper können zudem Anpresskräfte auf das Substrat bzw. den Grundkörper aufgebracht werden, ohne die Gefahr, dass bereits bestückte Bauteile dadurch beschädigt werden könnten, da das Substrat erst danach mit den Bauteilen bestückt wird. Es wird also vermieden, dass die zur Fixierung der Leiterplatte auf dem Grundkörper erforderlichen Anpresskräfte über die elektrischen Bauteile aufgebracht werden müssen. Vielmehr können die Kräfte vollflächig auf das Substrat und den Grundkörper aufgebracht werden, so dass eine sichere Befestigung des Substrats auf dem Grundkörper sichergestellt ist.

Ein weiterer Vorteil besteht in der hinreichenden Festigkeit der Substrat-Grundkörper-Einheit zur Montage der SMD (Surface Mounted Device)-Bauteile mit herkömmlichen Bestückungsautomaten sowie nach dem Einbringen der bestückten Substrat-Grundkörper-Einheit in ein Steuergerätegehäuse. Auf zusätzliche Konstruktionselemente zur Stabilisierung der Leiterplatte im Inneren des Steuergerätegehäuses kann aufgrund der hohen Formstabilität der fertig bestückten und in einer gewünschten Weise umgeformten Substrat-Grundkörper-Einheit verzichtet werden.

Die Grundkörper-Substrat-Einheit wird nach der Bestückung des Substrats so gebogen, dass der Grundkörper nach außen zeigt. Die nach außen zeigenden Kühlblechflächen des Grundkörpers bilden später einen Teil eines Steuergerätegehäuses, insbesondere die Außenseiten des Gehäuses.

Um die Grundkörper-Substrat-Einheit nach der Bestückung besser umformen zu können, wird der Grundkörper insbesondere im Bereich von Biegezonen geschlitzt. Die flexible Leiterplatte läuft vorzugsweise frei über die Schlitze im Metallkern, so dass sich das Flexboard beim Abwinkeln oder Umformen des Metallkerns frei biegen kann und nicht der Biegung des Metallkerns folgen muss, wobei es durch Ziehen oder Stauchen beschädigt würde.

Bei der vorliegenden Erfindung wird die Dichtigkeit der bestückten und umgeformten Grundkörper-Substrat-Einheit gegenüber Umwelteinflüssen (Schmutz, Feuchtigkeit) und elektromagnetischer Strahlung dadurch erzielt, dass die bestückte und umgeformte Einheit in einen ein- oder mehrteiligen Gehäuserahmen eingesetzt wird und zusammen mit diesem dann ein abgeschlossenes Steuergerätegehäuse bildet. Der Rahmen weist große Öffnungen auf, über die der Grundkörper mit der Umgebung in Verbindung steht. Die Schlitze im Grundkörper sind bei vollständig in den Rahmen eingesetzter Einheit durch Rahmenelemente des Gehäuserahmens verdeckt. Dadurch kann ein guter thermischer Übergang zwischen Teilflächen des Grundkörpers und der Umgebung gewährleistet werden, um die Verlustleistung der Bauelemente der Schaltung des Steuergeräts ungehindert an die Umgebung abgeben zu können.

Weitere Merkmale und Vorteile der Erfindung werden nachfolgend anhand von bevorzugten Ausführungsbeispielen unter Bezugnahme auf die Figuren näher erläutert. Dabei werden funktionsäquivalente Bauteile mit den gleichen Bezugszeichen bezeichnet. Es zeigen:
- Figur 1: eine erfindungsgemäße Beleuchtungseinrichtung für ein Kraftfahrzeug in einer perspektivischen Ansicht;
- Figur 2: eine perspektivische Ansicht eines aus dem Stand der Technik bekannten Steuergeräts für eine Beleuchtungseinrichtung in einer Explosionsdarstellung;
- Figur 3: den Vorgang eines Aufbringens und Befestigen einer flexiblen Leiterplatte auf eine Abwicklung eines starren Grundkörpers bei einem erfindungsgemäßen Steuergerät;
- Figur 4: eine fertig bestückte Grundkörper-SubstratEinheit eines erfindungsgemäßen Steuergeräts vor einem Umformen der Einheit in einer perspektivischen Ansicht;
- Figur 5a: den Vorgang eines Umformens der fertig bestückten Grundkörper-Substrat-Einheit mit in einer ersten Weise ausgestalteten Biegezonen in einer perspektivischen Ansicht;
- Figur 5b: die fertig umgeformte Grundkörper-SubstratEinheit aus Figur 5a in einer perspektivischen Ansicht;
- Figur 6a: den Vorgang eines Einsetzens der umgeformten Grundkörper-Substrat-Einheit aus Figur 5b in einen Gehäuserahmen gemäß einer ersten Ausführungsform in einer perspektivischen

- Figur 6b: Ansicht; das fertige erfindungsgemäße Steuergerät mit der in den Gehäuserahmen eingesetzten GrundkörperSubstrat-Einheit aus Figur 6a in einer perspektivischen Ansicht;
- Figur 7a: den Vorgang eines Einsetzens der umgeformten Grundkörper-Substrat-Einheit aus Figur 5b in einen Gehäuserahmen gemäß einer zweiten Ausführungsform in einer perspektivischen Ansicht;
- Figur 7b: das fertige erfindungsgemäße Steuergerät mit der in den Gehäuserahmen eingesetzten GrundkörperSubstrat-Einheit aus Figur 7a in einer perspektivischen Ansicht;
- Figur 8: den Vorgang eines Umformens der fertig bestückten Grundkörper-Substrat-Einheit mit in einer zweiten Weise ausgestalteten Biegezonen in einer perspektivischen Ansicht;
- Figur 9a: eine fertig bestückte Grundkörper-SubstratEinheit eines erfindungsgemäßen Steuergeräts vor einem Umformen der Einheit mit in einer dritten Weise ausgestalteten Biegezonen in einer perspektivischen Ansicht;
- Figur 9b: eine Detailansicht der Biegezonen der Grundkörper-Substrat-Einheit aus Figur 9a in einer Seitenansicht;
- Figur 10: den Vorgang eines Umformens der fertig bestückten Grundkörper-Substrat-Einheit gemäß Figur 9a mit in der dritten Weise ausgestalteten Biegezonen in einer perspektivischen Ansicht; und
- Figur 11: eine erfindungsgemäße Gasentladungslampe.

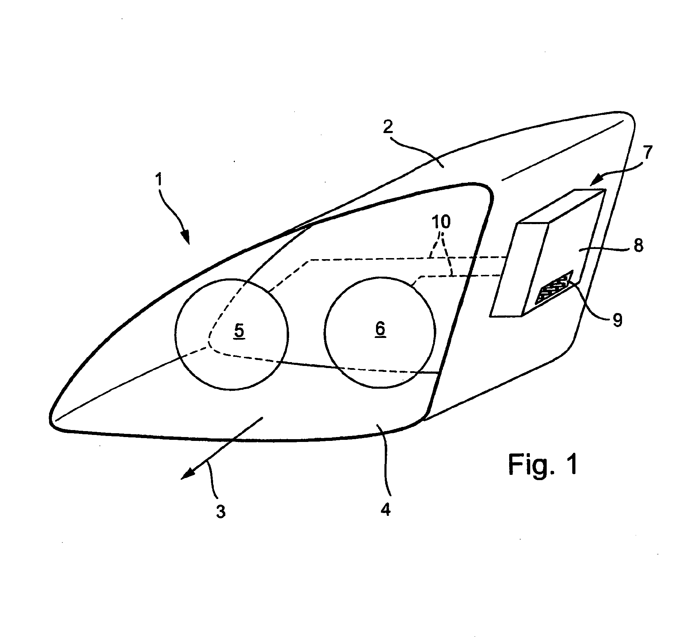

In Figur 1 ist eine erfindungsgemäße Beleuchtungseinrichtung für ein Kraftfahrzeug in ihrer Gesamtheit mit dem Bezugszeichen 1 bezeichnet. Die Beleuchtungseinrichtung 1 ist in dem dargestellten Ausführungsbeispiel als ein Frontscheinwerfer ausgebildet. Selbstverständlich kann sie jedoch auch als eine Leuchte, insbesondere als eine Heckleuchte, ausgebildet sein. Der Scheinwerfer 1 umfasst ein Gehäuse 2, das vorzugsweise aus Kunststoff besteht. Das Gehäuse 2 weist in Lichtaustrittsrichtung 3 eine Lichtaustrittsöffnung auf, die durch eine transparente Abdeckscheibe 4 verschlossen ist. Die Abdeckscheibe 4 kann ohne optisch wirksame Elemente (z.B. Prismen, etc.) ausgebildet sein (sog. klare Scheibe). Es ist aber auch denkbar, dass die Scheibe 4 zumindest teilweise mit optisch wirksamen Elementen ausgestattet ist, bspw. um eine Streuung des durch die Scheibe 4 hindurchtretenden Lichts in horizontaler Richtung zu bewirken. Bei einem Scheinwerfer ist die Scheibe 4 vorzugsweise farblos ausgestaltet. Bei einer Rückleuchte kann die Scheibe 4 eingefärbt sein, insbesondere rot für eine Leuchte für Rücklicht, Bremslicht oder Nebelschlusslicht und/oder gelb für eine Blinkleuchte.

Im Inneren des Scheinwerfergehäuses 2 sind zwei Lichtmodule 5, 6 angeordnet, die zur Erzeugung einer bestimmten Lichtverteilung ausgebildet sind. Die Lichtmodule 5, 6 können als Reflexionsmodule und/oder als Projektionsmodule ausgebildet sein. Ein Reflexionsmodul umfasst mindestens eine Lichtquelle zum Aussenden von Licht und einen Reflektor, der das ausgesandte Licht zur Erzeugung der gewünschten Lichtverteilung auf die Fahrbahn vor das Kraftfahrzeug reflektiert. Ein Projektionsmodul umfasst mindestens eine Lichtquelle zum Aussenden von Licht, eine Primäroptik (z.B. einen Reflektor oder eine Vorsatzoptik) zum Bündeln des ausgesandten Lichts und eine Sekundäroptik (z.B. eine Projektionslinse) zur Projektion des gebündelten Lichts auf die Fahrbahn vor das Kraftfahrzeug, um die gewünschte Lichtverteilung zu erzeugen. Falls die gewünschte Lichtverteilung eine Helldunkelgrenze aufweist, kann das Projektionsmodul zusätzlich noch eine zwischen Reflektor und Linse angeordnete Blendenanordnung aufweisen, deren Oberkante von der Sekundäroptik als Helldunkelgrenze auf die Fahrbahn projiziert wird. Selbstverständlich können die Lichtmodule, insbesondere wenn die Beleuchtungseinrichtung 1 als eine Leuchte ausgebildet ist, auch Lichtleiter und/oder andere optische Elemente aufweisen. Es ist denkbar, dass die Beleuchtungseinrichtung 1 weniger oder mehr als die dargestellten zwei Lichtmodule 5, 6 aufweist.

Die Lichtmodule 5, 6 des Scheinwerfers 1 aus Figur 1 können bspw. eine Abblendlicht-, Fernlicht-, Nebellicht-, Tagfahrlicht-, Positionslicht-, Standlicht-, Blinklicht-, Stadtlicht-, Landstraßenlicht-, Autobahnlicht-, statische oder dynamische Kurvenlicht- oder eine beliebig andere statische oder adaptive Lichtverteilung erzeugen. Die Lichtmodule 5, 6 können die gewünschte Lichtverteilung alleine oder im Zusammenwirken miteinander oder mit anderen, nicht gezeigten Lichtmodulen des Scheinwerfers 1 erzeugen. Dabei werden die Teillichtverteilungen der Lichtmodule 5, 6 oder anderer Lichtmodule zu der gewünschten resultierenden Gesamtlichtverteilung überlagert. Bei einer als Heckleuchte ausgebildeten Beleuchtungseinrichtung 1 können die Lichtmodule eine Rücklicht-, Bremslicht-, Nebelschlusslicht-, Blinklicht-, Rückfahrlicht- oder eine beliebig andere Lichtverteilung erzeugen.

Außen an dem Gehäuse 2 der Beleuchtungseinrichtung 1 ist ein Steuergerät 7 angeordnet, das ein Gehäuse 8 aufweist, das vorzugsweise aus Metall, insbesondere Aluminiumdruckguss, besteht. Das Steuergerätegehäuse 8 umfasst einen Stecker- oder Buchsenelement 9, über welches das Steuergerät 7 an eine Energieversorgung des Kraftfahrzeugs, bspw. eine Fahrzeugbatterie, und/oder an ein übergeordnetes Steuergerät (z.B. sog. Body Controller) angeschlossen ist. Das Steuergerätegehäuse 8 ist auf einer Öffnung (nicht dargestellt) im Scheinwerfergehäuse 2 angeordnet, durch die Leitungen 10 vom Steuergerät 7 zu den Lichtmodulen 5, 6 hindurchgeführt sind. Um ein Eindringen von Feuchtigkeit und Schmutz in das Innere des Scheinwerfergehäuses 2 zu verhindern, ist das Steuergerätegehäuse 8 gegenüber dem Scheinwerfergehäuse 2 abgedichtet, bspw. mittels geeigneter Dichtmittel, insbesondere mittels einer um die Öffnung des Gehäuses 2 verlaufenden Dichtlippe aus elastischem Material. Selbstverständlich kann das Steuergerät 8 auch an einer anderen als der in Figur 1 gezeigten Stelle am Scheinwerfer 1 angeordnet sein. Außerdem ist es denkbar, dass das Steuergerät 7 nicht außen, sondern innen am Gehäuse 2 oder an einer beliebig anderen Stelle separat vom Scheinwerfergehäuse 2 angeordnet ist. In diesem Zusammenhang wäre es bspw. denkbar, dass das Steuergerät 7 integraler Bestandteil eines Lichtmoduls 5; 6, insbesondere integraler Bestandteil einer Lichtquelle eines Lichtmoduls 5; 6, ist. So sind bspw. Gasentladungslampen (z.B. vom Type D1S) bekannt, bei denen an der Rückseite ein Zündgerät in einem Metallgehäuse integriert ist. Es wäre denkbar, die Schaltung des Steuergeräts 7 in das Zündgerätegehäuse zu integrieren. Dies wäre mit der vorliegenden Erfindung besonders gut möglich, da sich damit die Schaltungen von Steuergeräten 7 besonders dicht gepackt und damit kleinbauend realisieren lassen.

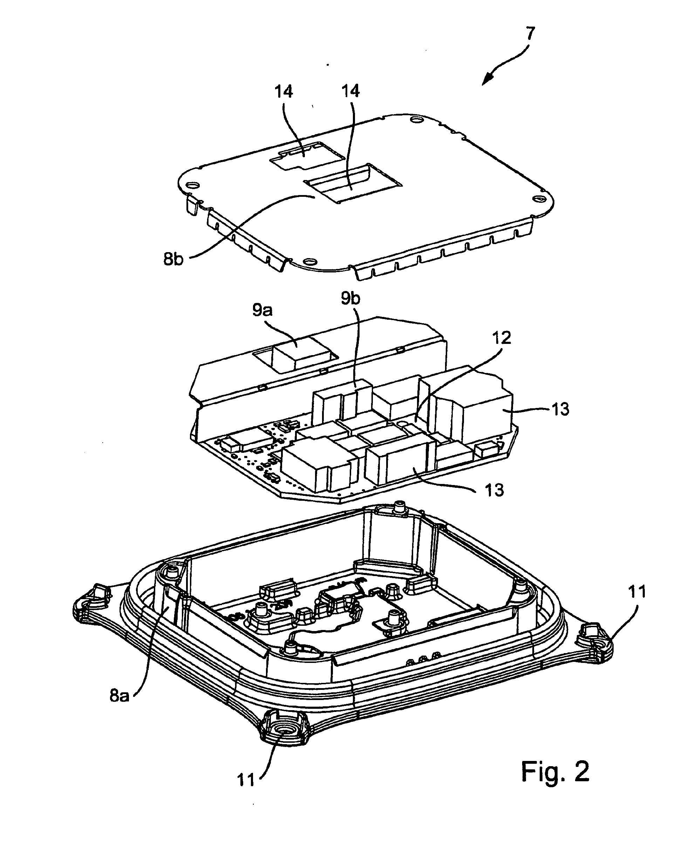

Ein aus dem Stand der Technik bekanntes Steuergerät 7 ist in Figur 2 gezeigt. Das Gehäuse 8 umfasst einen Grundkörper 8a sowie einen Deckel 8b. Der Deckel 8b kann auf den Grundkörper 8a aufgesetzt und mittels Schrauben befestigt werden, so dass der Innenraum des Gehäuses 8 feuchtigkeits-und staubdicht abgeschlossen ist. Außen am Grundkörper 8a sind Ösen 11 zu Befestigung des Steuergeräts 7 an der Außenseite des Scheinwerfergehäuses 2 oder an einer beliebig anderen Stelle vorgesehen. Die Befestigung des Steuergeräts 7 erfolgt bspw. mittels Schrauben. Im Inneren des Gehäuses 8 sind auf einer oder mehreren starren Leiterplatten 12 elektronische Bauteile 13 angeordnet und mittels Leiterbahnen (nicht dargestellt) derart miteinander verschaltet, dass das Steuergerät 7 eine gewünschte Steuerungs- und/oder Regelungsfunktion im Zusammenhang mit dem Betrieb der Beleuchtungseinrichtung 1 erfüllen kann. Auf der Leiterplatte 12 sind des weiteren auch zwei Buchsen- oder Steckerelemente 9a, 9b angeordnet und elektrisch kontaktiert, an die von außen durch Öffnungen 14 im Gehäuse 8 geeignete Stecker-/Buchsenelemente (nicht dargestellt) angeschlossen werden können. Die Fläche der Leiterplatte 12 bestimmt im Wesentlichen die Hauptabmessungen des Steuergerätegehäuses 8.

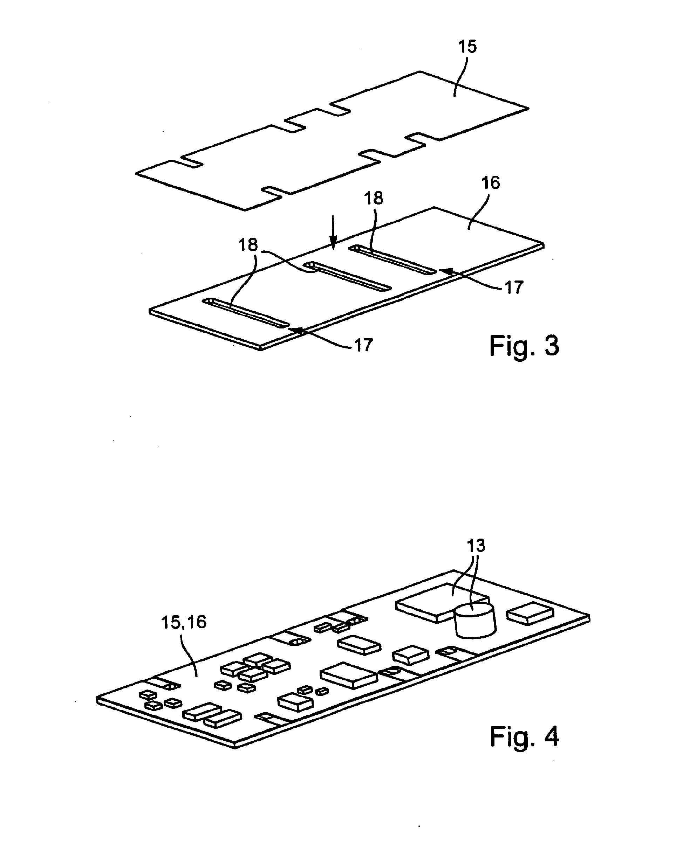

Die elektronischen Bauteile 13 erzeugen während des Betriebs des Steuergeräts 7 Abwärme, die aus dem Inneren des Gehäuses 8 nach außen abgeführt werden muss, um einen Hitzestau und eine Beschädigung oder Funktionsstörung der elektronischen Bauteile 13 zu vermeiden. Gleichzeitig soll das Steuergerät 7 möglichst kleinbauend und leicht ausgebildet sein. Dies wird durch das erfindungsgemäße Steuergerät 7 ermöglicht, das nachfolgend anhand der Figuren 3 bis 10 näher erläutert wird.

Bei den erfindungsgemäßen Steuergeräten 7 ist, wie aus Figur 3 ersichtlich, die Leiterplatte als ein flexibles Substrat 15 ausgebildet, das unbestückt auf einen ebenen, starren, biegbaren Grundkörper 16 aus einem gut wärmeleitfähigen Material aufgebracht und darauf befestigt ist. Der Grundkörper 16 sollte außerdem aus einem Material bestehen, das elektromagnetische Strahlung gut abschirmen kann. Diese Anforderungen werden bspw. von Metall erfüllt. Der Grundkörper 16 besteht bspw. aus einem Aluminiumblech. Das flexible Substrat 15 wird auch als Flexboard bezeichnet. Die Befestigung des Substrats 15 auf dem Grundkörper 16 kann bspw. mittels Kleben, Auflaminieren oder auf beliebig andere Weise erfolgen. Der Grundkörper 16 weist an verschiedenen Stellen, vorzugsweise im Bereich von Biegezonen 17, an denen die Grundkörper-Substrat-Einheit 15, 16 nach der Bestückung umgeformt wird, Schlitze 18 auf, um das Umformen zu erleichtern. Im Bereich der Biegezonen 17 ist das Substrat 15 nicht am Grundkörper 16 befestigt. Der Grundkörper 16 dient als stabilisierendes Element für das flexible Substrat 15 während der Bestückung mit den Bauelementen 13, als wärmeableitendes Element für die Abwärme der Bauelemente 13 sowie als Halterung der bestückten und umgeformten Grundkörper-Substrat-Einheit 15, 16 in dem Steuergerätegehäuse 8 bzw. sogar als Teil des Steuergerätegehäuses 8. Außerdem dient der Grundkörper 16 der Verbesserung der EMV-Verträglichkeit, da die Bauelemente 13 und die auf der Leiterplatte 15 ausgebildeten Leiterbahnen durch den Grundkörper 16 nach außen hin abgeschirmt sind.

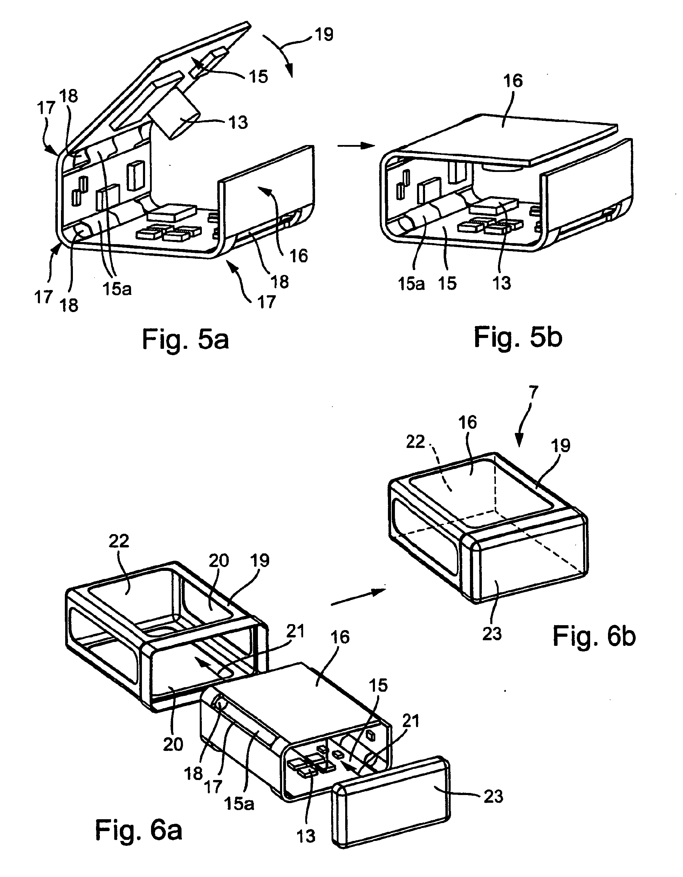

Das Substrat 15 wird vor der Bestückung mit den elektronischen Bauteilen 9, 13 auf eine Abwicklung des Grundkörpers 16 aufgebracht. Anschließend wird die Grundkörper-Substrat-Einheit 15, 16 im ebenen Zustand bspw. mittels herkömmlicher Bestückungsautomaten bestückt. Die Grundkörper-Substrat-Einheit 15, 16 ist nach dem Bestücken und vor einem Umformen in Figur 4 gezeigt. Dann erfolgt eine Umformung (Pfeil 19 in Figur 5a) der bestückten Grundkörper-Substrat-Einheit 15, 16 in eine gewünschte Geometrie. Das Substrat 15 läuft über die Schlitze 18 frei hinweg. Im Bereich der Biegezonen 17, wo das Substrat 15 nicht auf dem Grundkörper 16 befestigt ist, können sich die lockeren, flexiblen Substratabschnitte 15a von der Grundfläche 16 lösen und fei verformen, insbesondere einen beliebigen Biegeradius annehmen. Insbesondere muss das Flexboard 15 im Bereich der Biegezonen 17 nicht der Biegung des Grundkörpers 16 folgen. Dadurch wird eine Beschädigung des Flexboards 15 durch Stecken oder Stauchen im Bereich der Biegezonen 17 wirksam verhindert.

Die Grundkörper-Substrat-Einheit 15, 16 kann so geformt werden, dass sie den Innenraum eines Steuergerätegehäuses 8 möglichst effizient ausnutzt. Außerdem kann sie so geformt werden, dass der metallische Grundkörper 16 selbst zumindest einen Teil des Gehäuses 8 bilden kann. Auf diese Weise kann zumindest auf Teile eines separaten Steuergerätegehäuses 8 verzichtet und die Kühlung der Bauelemente 13 und die Wärmeabfuhr aus dem Inneren des Gehäuses 8 verbessert werden. Die bestückte und fertig umgeformte Grundkörper-Substrat-Einheit 15, 16 ist in Figur 5b gezeigt. Diese wird in dem in Figur 6a gezeigten Ausführungsbeispiel zur Stabilisierung in einen Gehäuserahmen 19 eingesetzt. Der Gehäuserahmen 19 hat seitlich im Bereich von Kühlflächen der Grundkörper-Substrat-Einheit 15, 16 große Öffnungen 20, durch die Verlustwärme aus dem Steuergerät 7 direkt über den Kühlflächen bildenden Grundkörper 16 an die Umgebung abgegeben werden. Der Rahmen 19 ist derart ausgestaltet, dass er Öffnungen in dem Grundkörper 16, bspw. im Bereich der Umformungszonen 17, verschließt. In Figur 6a wird die Grundkörper-Substrat-Einheit 15, 16 in Richtung von Pfeilen 21 in den Gehäuserahmen 19 eingeschoben, bis sie an einer der Einführöffnung des Rahmens 19 gegenüberliegenden Gehäusewand 22 oder davor vorgesehenen Anschlagselementen zur Anlage gelangt. Danach wird die Einführöffnung des Rahmens 19 durch einen Gehäusedeckel 23 verschlossen. Wie anhand der Figur 6b zu erkennen, wird das Steuergerätegehäuse 8 also durch den Gehäuserahmen 19, den gefalteten Grundkörper 16, die mit dem Rahmen 19 verbundene Rückwand 22 und den Gehäusedeckel 23 gebildet.

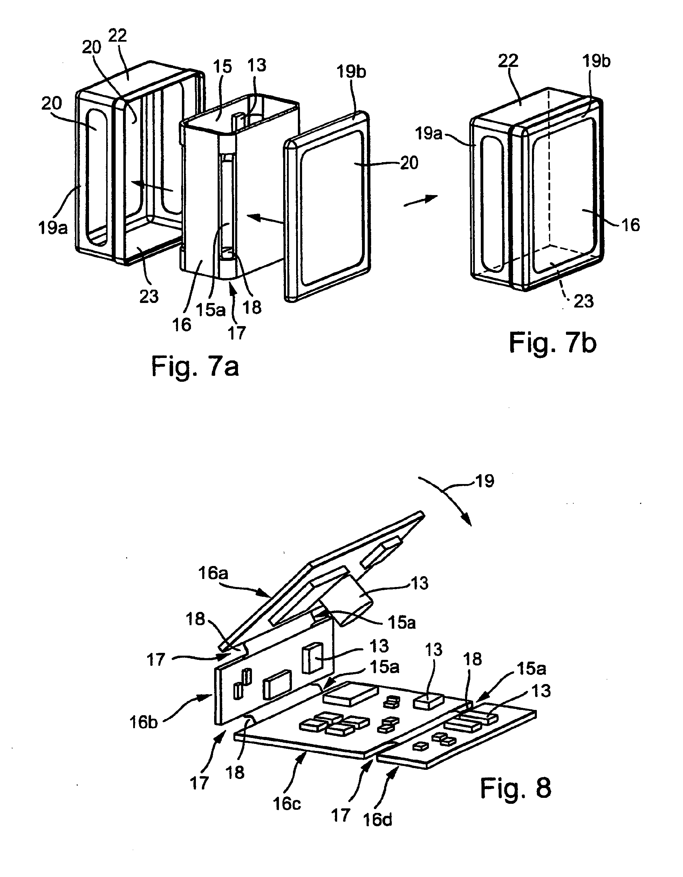

Gemäß einer alternativen Ausführungsform des erfindungsgemäßen Steuergeräts 7 ist, wie in den Figuren 7a und 7b dargestellt, der Gehäuserahmen 19 zweigeteilt ausgebildet. Der Deckel 23 der Ausführungsform aus Figur 6 ist hier in Form einer gegenüber der Rückwand 22 angeordneten Vorderwand integraler Bestandteil eines ersten Teils 19a des Gehäuserahmens 19. Der Deckel zum Verschließen der Einführöffnung ist durch einen zweiten Teil 19b des Rahmens 19 gebildet. In beiden Teilen 19a, 19b des Rahmens 19 sind großflächige Öffnungen ausgebildet, die durch große Flächen des metallischen Grundkörpers 16 ausgefüllt werden. Auch bei dieser Ausführungsform ist es so, dass der Gehäuserahmen 19a, 19b vorzugsweise so ausgebildet ist, dass er in der Grundplatte 16 ausgebildete Öffnungen, insbesondere die Schlitze 18, verschließt. Das Steuergerätegehäuse 8 wird hier also durch die beiden Teile 19a, 19b des Gehäuserahmens 19, die Vorderwand 23 und die Rückwand 22 sowie den metallischen Grundkörper 16 gebildet.

Gemäß einer weiteren, in Figur 8 dargestellten Ausführungsform der Erfindung kann der Grundkörper 16 im Bereich der Umformungszonen 17 auch komplett unterbrochen, z.B. freigestanzt oder freigefräst, sein. Die dadurch entstehenden Grundkörper- oder Kühlblechteile 16a, 16b, 16c und 16d sind nur noch durch die flexible Leiterplatte 15 bzw. die Abschnitte 15a im Bereich der Biegezonen 17 der Leiterplatte 15 miteinander verbunden. Die Grundkörper-Substrat-Einheit 15, 16 kann dadurch auf besonders einfache Weise und ohne große Kraftanstrengung umgeformt (vgl. Pfeil 19 in Figur 8), insbesondere gefaltet und in einen Gehäuserahmen 19; 19a, 19b eingesetzt werden. Allerdings sind hierbei die Anforderungen an den Gehäuserahmen 19; 19a, 19b bezüglich Stabilität höher als bei dem Ausführungsbeispiel gemäß Figur 5a, da die mechanische Stabilisierung der Grundkörper-Substrat-Einheit 15, 16 nunmehr nahezu vollständig durch den Rahmen 19; 19a, 19b besorgt werden muss. Die gefaltete Leiterplatte 15 besitzt kaum eine mechanische Stabilität.

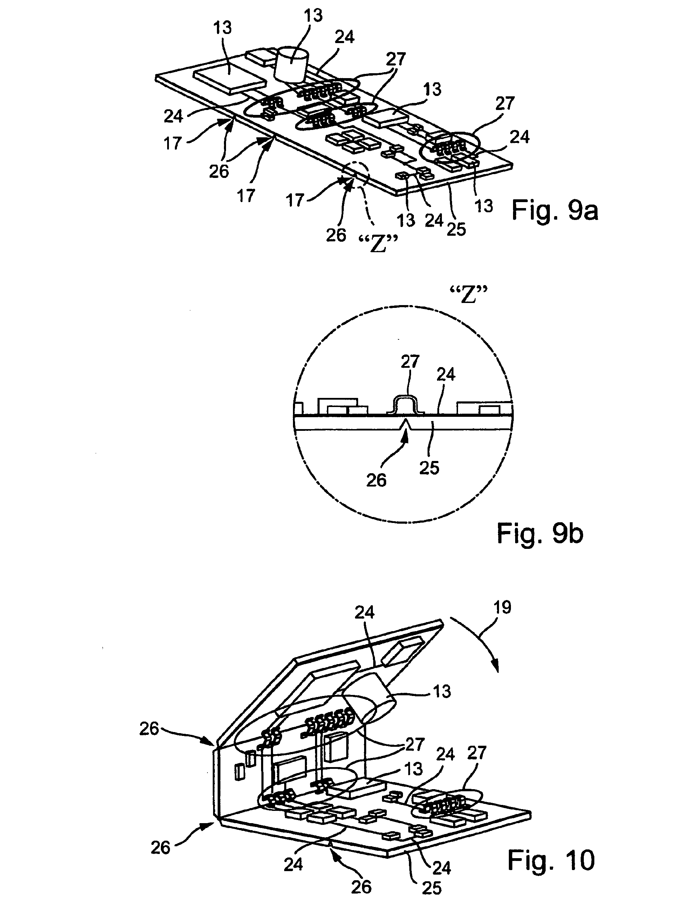

Die Figuren 9a und 9b zeigen eine weitere alternative Ausführungsform der Erfindung. Dabei wird anstelle eines Kühlblech-Flexboard-Laminats 15, 16 eine Metallkernplatine verwendet. Hierbei werden Leiterbahnschichten mit Leiterbahnen 24 und Isolierschichten auf einen Metallkern 25 auflaminiert und gemeinsam ausgestanzt oder gefräst. Leiterbahnschichten, Isolierschichten und Metallkern haben also dieselbe Außenkontur. Um die Metallkernplatine 24, 25 gezielt umformen, d.h. biegen oder falten zu können, wird die Materialstärke in den Biegezonen 17, insbesondere im Bereich von Biegekanten, auf der Seite des Metallkerns 25 (Rückseite) durch Nuten 26 verringert. Damit die Leiterbahnen 24 beim Umformen der Metallkernplatine 24, 25 nicht beschädigt werden, müssen die Leiterbahnen 24 in den Biegezonen 17 unterbrochen und mit flexiblen Leitern 27, z.B. Flex-Jumpern oder Folienkabel, überbrückt werden. Die Überbrückungselemente 27 sind vorzugsweise auf der Bestückungsseite der Metallkernplatine 24, 25 angeordnet. Die Überbrückungselemente 27 können sich unabhängig von der Biegung des Metallkerns 25 frei verformen. Flex-Jumper 27 sind kleine flexible Leiterbahnen, die zusammen mit den übrigen elektronischen Bauteilen 13 bestückt werden.

Wie in Figur 10 dargestellt, kann die Metallkernplatine 24, 25 aus Figur 9a umgeformt werden (vgl. Pfeil 19), um sie dann in einem Gehäuserahmen, wie bspw. einem Gehäuserahmen 9 oder 9a, 9b gemäß Figur 6a oder 7a, einzusetzen. Auch bei diesem Ausführungsbeispiel stabilisiert der Rahmen Platine 24, 25 und verschließt das Gehäuse 8 dicht (vgl. Figur 6b, 7b). Auch hier bildet der Metallkern 25 gleichzeitig die Außenseite eines Steuergerätegehäuses 8, um die ungehinderte Wärmeabfuhr an die Umgebung zu ermöglichen.

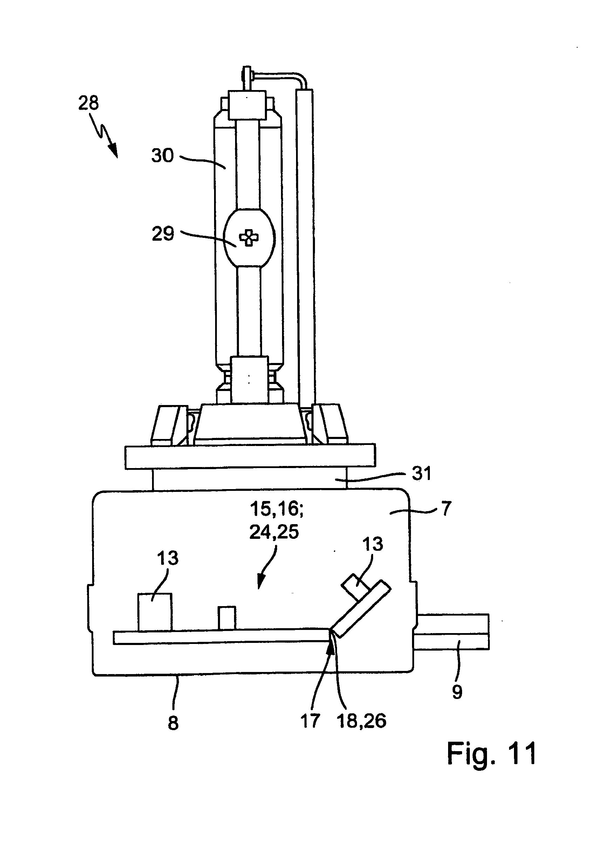

Durch die hochintegrierte, kompakte Ausgestaltung der Schaltung eines Steuergeräts 7 ist es erst möglich, bei Gasentladungslampen für Kraftfahrzeuge Brenner, Zünder und Steuergerät 7 als eine einzige Einheit auf engstem Raum auszubilden. Dabei sind Zünder und Steuergerät 7 vorzugsweise in einem gemeinsamen Gehäuse integriert, das an der Rückseite der Lampe angeordnet ist. Eine entsprechende Gasentladungslampe 28 ist beispielhaft in Figur 11 dargestellt. Die Lampe 28 weist einen mit einem Edelgas oder einem Gasgemisch gefüllten Brenner 29 auf, in dem ein Lichtbogen gezündet und aufrechterhalten wird, der Licht aussendet. Der Brenner 29 ist vorzugsweise als ein Glaskolben, insbesondere aus einem Quarzglas, ausgebildet. Er ist seinerseits in einem weiteren Glaskolben 30 angeordnet. Der Glaskolben 30 ist an einem Lampensockel 31 befestigt, über den die Lampe 28 mittelbar oder unmittelbar an einem Reflektorhals lösbar befestigt wird. Auf der dem Glaskolben 30 abgewandten Rückseite der Lampe 28 ist das kombinierte Zünd-Steuergerät 7 in einem gemeinsamen Gehäuse 8 angeordnet. Im Inneren des Gehäuses 8 ist die Grundkörper-Substrat-Einheit 15, 16 bzw. die Metallkernplatine 24, 25 als wesentlicher Teil der hochintegrierten Schaltung des erfindungsgemäßen Steuergeräts 7 symbolisch dargestellt. Die Schaltung des Zündgeräts ist also integraler Bestandteil der Steuergeräteschaltung und ebenfalls in dem Gehäuse 8 angeordnet.

Bei einer solchen hochintegrierten Ausgestaltung einer Gasentladungslampe ist eine gute Wärmeabfuhr besonders wichtig. Die erfindungsgemäße Ausgestaltung des Steuergeräts 7 mit auflaminierten Kühlblechen 16, 24 und einem stabilisierenden Gehäuserahmen 9; 9a, 9b ermöglicht die Fertigung auf konventionellen Bestückungsautomaten und stellt einen mechanisch geschlossenen Verbund mit optimaler Wärmeabfuhr sicher.

## Patentansprüche

1. Elektronisches Steuergerät (7) für eine Beleuchtungseinrichtung (1) eines Kraftfahrzeugs, das Steuergerät (7) umfassend eine mit elektrischen Leiterbahnen versehene und mit elektronischen Bauteilen (13) bestückte Leiterplatte (15) sowie einen mit der Leiterplatte (15) in thermischem Kontakt stehenden Grundkörper (16; 25) aus einem Material mit hoher Wärmeleitfähigkeit, wobei der Grundkörper (16; 25) zumindest einen Teil des Steuergerätegehäuses (8) bildet und wobei das Steuergerät (7) einen Gehäuserahmen (19; 19a, 19b) aufweist, in den die umgeformte Grundkörper-Leiterplatten-Einheit (15, 16) eingesetzt ist, so dass der Rahmen (19; 19a, 19b) zusammen mit dem Grundkörper (16; 25) das Steuergerätegehäuse (8) bildet, **dadurch gekennzeichnet, dass** die Leiterplatte (15) vor der Bestückung mit den elektronischen Bauteilen (13) auf eine Abwicklung des Grundkörpers (16; 25) aufgebracht und zumindest bereichsweise darauf befestigt ist, und dass eine Umformung der bestückten Grundkörper-Leiterplatten-Einheit (15, 16) in eine gewünschte Geometrie nach der Bestückung mit den elektronischen Bauteilen (13) erfolgt, wobei der Grundkörper (16; 25) im Bereich von Biegezonen geschlitzt ist und Rahmenelemente des Gehäuserahmens (19; 19a, 19b) bei vollständig in den Rahmen (19; 19a, 19b) eingesetzter Grundkörper-Leiterplatten-Einheit (15, 16) die Schlitze in dem Grundkörper (16; 25) verdecken.

2. Steuergerät (7) nach Anspruch 1, **dadurch gekennzeichnet, dass** die Leiterplatte (15) ein flexibles Substrat umfasst, das auf einen Grundkörper (16) aus Metall aufgebracht und zumindest bereichsweise befestigt ist.

3. Steuergerät (7) nach Anspruch 1, **dadurch gekennzeichnet, dass** der Grundkörper als ein Metallkern (25) einer Metallkernplatine ausgebildet ist, auf den zumindest bereichsweise Leiterbahnen (24) aufgebracht und befestigt sind.

4. Steuergerät (7) nach Anspruch 2 oder 3, **dadurch gekennzeichnet, dass** das flexible Substrat (15) bzw. die Leiterbahnen (24) auf den Grundkörper (16) bzw. den Metallkern (25) auflaminiert oder aufgeklebt sind.

5. Steuergerät (7) nach einem der Ansprüche 1 bis 4, **dadurch gekennzeichnet, dass** die Umformung der Grundkörper-Substrat-Einheit (15, 16) bzw. der Grundkörper-Leiterbahnen-Einheit (24; 25) in die gewünschte Geometrie durch Biegen der Einheit (15, 16; 24, 25) im Bereich von Biegezonen (17) erfolgt, wobei im Bereich der Biegezonen (17) keine Befestigung des flexiblen Substrats (15) auf dem Grundkörper (16) vorgesehen ist bzw. keine Leiterbahnen (24) auf dem Grundkörper (25) angeordnet sind.

6. Steuergerät (7) nach einem der Ansprüche 1 bis 4, **dadurch gekennzeichnet, dass** die Umformung der Grundkörper-Substrat-Einheit (15, 16) bzw. der Grundkörper-Leiterbahnen-Einheit (24; 25) in die gewünschte Geometrie durch Biegen der Einheit (15, 16; 24, 25) im Bereich von Biegezonen (17) erfolgt, wobei der Grundkörper (16; 25) im Bereich der Biegezonen (17) eine gegenüber dem übrigen Grundkörper (16; 25) verringerte Materialstärke aufweist.

7. Steuergerät (7) nach Anspruch 6, **dadurch gekennzeichnet, dass** der Grundkörper (16; 25) im Bereich der Biegezonen (17) zumindest teilweise unterbrochen ist.

8. Steuergerät (7) nach einem der Ansprüche 1 bis 7, **dadurch gekennzeichnet, dass** bei der umgeformten Grundkörper-Substrat-Einheit (15, 16) bzw. Grundkörper-Leiterbahnen-Einheit (24, 25) in die gewünschte Geometrie der Grundkörper (16; 25) nach außen und das flexible Substrat (15) bzw. die Leiterbahnen (24) nach innen zeigen.

9. Gasentladungslampe (28) für eine Beleuchtungseinrichtung (1) eines Kraftfahrzeugs, die Lampe (28) umfassend einen Brenner (29), ein Zündgerät und ein Steuergerät (7), **dadurch gekennzeichnet, dass** das Steuergerät (7) nach einem der Ansprüche 1 bis 8 ausgestaltet ist und dass es zusammen mit dem Zündgerät in einem gemeinsamen Gehäuse (8) integriert ist.

## Claims

1. An electronic control device (7) for a lighting device (1) of a motor vehicle, the control device (7) including a printed circuit board (15), provided with electronic conductor tracks and assembled with electronic components (13), and including a base body (16; 25) that is in thermal contact with the printed circuit board (15) and comprises a material with high thermal conductivity, and the base body (16; 25) forms at least a part of the control device housing (8), and the control device (7) has a housing frame (19; 19a, 19b) into which the shaped base-body/circuit board unit (15, 16) is inserted, so that the frame (19; 19a, 19b) together with the base body (16; 25) forms the control device housing (8), **characterized in that** the printed circuit board (15), before being assembled with the electronic components (13), is placed on the flattened-out base body (16; 25) and secured there at least in some regions, and that deforming of the assembled base-body/circuit board unit (15, 16) into a desired geometry is effected after it has been assembled with the electronic components (13), and the base body (16; 25) is slit in the region of bending zones, and once the base-body/circuit board unit (15, 16) has been fully inserted into the frame (19; 19a, 19b), frame elements of the housing frame (19; 19a, 19b) conceal the slits in the base body (16; 25).

2. The control device (7) of claim 1, **characterized in that** the printed circuit board (15) includes a flexible substrate, which is placed on a metal base body (16) and secured in at least some regions.

3. The control device (7) of claim 1, **characterized in that** the base body is embodied as a metal core (25) of the metal core circuit board, on which conductor tracks (24) are placed and secured at least in some regions.

4. The control device (7) of claim 2 or 3, **characterized in that** the flexible substrate (15) and/or the conductor tracks (24) are laminated or glued onto the base body (16) and/or the metal core (25).

5. The control device (7) of one of claims 1 through 4, **characterized in that** the deforming of the base body-substrate unit (15, 16) and/or the base-body/circuit board unit (24; 25) into the desired geometry is effected by bending the unit (15, 16; 24, 25) in the vicinity of bending zones (17), and in the vicinity of the bending zones (17), no securing of the flexible substrate (15) on the base body (16) is provided and/or no conductor tracks (24) are disposed on the base body (25).

6. The control device (7) of one of claims 1 through 4, **characterized in that** the deforming of the base body-substrate unit (15, 16) /or the base-body/circuit board unit (24; 25) into the desired geometry is effected by bending the unit (15, 16; 24, 25) in the vicinity of bending zones (17), and in the vicinity of the bending zones (17), the base body (16; 25) has a reduced material thickness compared to the remainder of the base body (16; 25).

7. The control device (7) of claim 6, **characterized in that** the base body (16; 25) is at least partially interrupted in the vicinity of the bending zones (17).

8. The control device (7) of one of claims 1 through 7, **characterized in that** when the base body-substrate unit (15, 16) and/or the base-body/circuit board unit (24, 25) is deformed into the desired geometry, the base body (16; 25) points outward, and the flexible substrate (15) and/or the conductor tracks (24) point inward.

9. A gas discharge lamp (28) for a lighting device (1) of a motor vehicle, the lamp (28) including a burner (29), an ignition device, and a control device (7), **characterized in that** the control device (7) is embodied in accordance with one of claims 1 through 8, and it is integrated together with the ignition device in a common housing (8).

## Revendications

1. Contrôleur électronique (7) pour un dispositif d'éclairage (1) d'un véhicule automobile, le contrôleur (7) comprenant un circuit imprimé (15) muni de pistes électriquement conductrices et garni de composants électroniques (13) ainsi qu'un corps de base (16; 25) en un matériau à conductivité thermique élevée qui se trouve en contact thermique avec le circuit imprimé (15), le corps de base (16; 25) formant au moins une partie du boîtier de contrôleur (8) et le contrôleur (7) présentant un cadre de boîtier (19; 19a, 19b) dans lequel est inséré l'ensemble corps de base - circuit imprimé (15, 16) façonné, de sorte que le cadre (19; 19a, 19b), conjointement avec le corps de base (16; 25), forme le boîtier de contrôleur (8), **caractérisé en ce que** le circuit imprimé (15), avant d'être garni des composants électroniques (13), est monté sur une projection du corps de base (16; 25) et fixée sur celle-ci au moins dans certaines zones, et **en ce qu'**un façonnage de l'ensemble corps de base - circuit imprimé (15, 16) garni dans une forme géométrique souhaitée est réalisé après la garniture avec les composants électroniques (13), le corps de base (16; 25) étant fendu dans la zone des zones de flexion et les éléments de cadre du cadre de boîtier (19; 19a, 19b) recouvrant les fentes dans le corps de base (16; 25) lorsque l'ensemble corps de base - circuit imprimé (15, 16) est entièrement inséré dans le cadre (19; 19a, 19b).

2. Contrôleur (7) selon la revendication 1, **caractérisé en ce que** le circuit imprimé (15) comprend un substrat flexible qui est appliqué sur un corps de base (16) en métal et fixé au moins dans certaines zones.

3. Contrôleur (7) selon la revendication 1, **caractérisé en ce que** le corps de base est réalisé sous la forme d'une âme métallique (25) d'une platine à âme métallique sur laquelle des pistes conductrices (24) sont montées et fixées au moins dans certaines zones.

4. Contrôleur (7) selon la revendication 2 ou 3, **caractérisé en ce que** le substrat flexible (15) ou les pistes conductrices (24) sont laminés ou collés sur le corps de base (16) ou l'âme métallique (25).

5. Contrôleur (7) selon l'une des revendications 1 à 4, **caractérisé en ce que** le façonnage de l'ensemble corps de base - substrat (15, 16) ou l'ensemble corps de base - pistes conductrices (24; 25) dans la forme géométrique souhaitée s'effectue en pliant l'ensemble (15, 16; 24, 25) dans la zone des zones de flexion (17), aucune fixation du substrat flexible (15) sur le corps de base (16) n'étant prévue ou aucune piste conductrice (24) n'étant disposée sur le corps de base (25) dans la zone des zones de flexion (17).

6. Contrôleur (7) selon l'une des revendications 1 à 4, **caractérisé en ce que** le façonnage de l'ensemble corps de base - substrat (15, 16) ou de l'ensemble corps de base - pistes conductrices (24; 25) dans la forme géométrique souhaitée s'effectue en pliant l'ensemble (15, 16; 24, 25) dans la zone des zones de flexion (17), le corps de base (16; 25) présentant dans la zone des zones de flexion (17) une épaisseur de matériau réduite par rapport au reste du corps de base (16; 25).

7. Contrôleur (7) selon la revendication 6, **caractérisé en ce que** le corps de base (16; 25) est au moins partiellement interrompu dans la zone des zones de flexion (17).

8. Contrôleur (7) selon l'une des revendications 1 à 7, **caractérisé en ce que** lorsque l'ensemble corps de base - substrat (15, 16) ou l'ensemble corps de base - pistes conductrices (24; 25) est façonné dans la forme géométrique souhaitée, le corps de base (16; 25) est dirigé vers l'extérieur et le substrat flexible (15) ou les pistes conductrices (24) vers l'intérieur.

9. Lampe à décharge gazeuse (28) pour un dispositif d'éclairage (1) d'un véhicule automobile, la lampe (28) comprenant un brûleur (29), un dispositif d'amorçage et un contrôleur (7), **caractérisée en ce que** le contrôleur (7) est configuré selon l'une des revendications 1 à 8 et **en ce qu'**il est intégré dans un boîtier (8) commun conjointement avec le dispositif d'amorçage.
